# EUROPEAN PATENT APPLICATION

(11) **EP 4 258 014 A1**
(43) Date of publication of application: **11.10.2023**
(21) Application number: 22166788.4
(22) Date of filing: 05.04.2022
(51) Int. Cl.: G01S 7/481, H01L 27/146, G01S 17/36, G01S 7/4861, G01S 7/4913

(54) **OPTICAL SENSOR AND METHOD FOR FABRICATING AN OPTICAL SENSOR**

(71) Applicant: Infineon Technologies AG, 85579 Neubiberg (DE)
(72) Inventor: MONO, Tobias, 01099 Dresden (DE); VIETZKE, Dirk, 85591 Vaterstetten (DE)
(74) Representative: Lambsdorff & Lange Patentanwälte Partnerschaft mbB

(57) **Abstract**

An optical sensor comprises at least one pixel, the pixel comprising: a photoactive region configured to convert photons into electrons and holes, a first and a second modulation gate configured to be modulated for indirect time of flight measurement, the first and second modulation gates being arranged on a front side of the pixel, above the photoactive region or extending into the photoactive region, a first and a second trench arranged on opposite lateral sides of the photoactive region, the trenches extending from the front side into the pixel, and a first memory part arranged laterally next to the first trench and at least partially separated from the photoactive region by the first trench and a second memory part arranged laterally next to the second trench and at least partially separated from the photoactive region by the second trench, the first and second memory parts being configured to bin electrons generated in the photoactive region when the first, respectively the second modulation gate is active, wherein the first and second trenches comprise air gaps configured to act as reflective structures for photons in the photoactive region.

## Description

### TECHNICAL FIELD

This disclosure relates in general to an optical sensor, in particular to an optical sensor, wherein a pixel of the sensor comprises a first and a second trench, as well as to a method for fabricating such an optical sensor.

### BACKGROUND

Optical sensors based on semiconductor devices may be employed for a wide variety of purposes. For example, such optical sensors may be used for measuring a distance between the sensor and an object or for measuring a velocity of that object. However, the performance of such optical sensors, which may for example be time of flight sensors, may be negatively impacted by an effect called "parasitic light sensitivity" (PLS). This problem may occur when photons are absorbed not in a dedicated photoactive region of a pixel of the sensor but instead in a memory part of the pixel. Unlike electrons generated by photons in the photoactive region, electrons generated in the memory part are not modulated by a modulation part of the pixel and therefore increase the noise level in the pixel. Furthermore, it may be desirable to achieve a high full-well-capacitance and/or to be able to deplete the memory part(s) of such a pixel particularly quickly. Improved optical sensors and improved methods for fabricating optical sensors may help with solving these and other problems.

The problem on which the invention is based is solved by the features of the independent claims. Further advantageous examples are described in the dependent claims.

### SUMMARY

Various aspects pertain to an optical sensor, comprising: at least one pixel, the pixel comprising: a photoactive region configured to convert photons into electrons and holes, a first and a second modulation gate configured to be modulated for indirect time of flight measurement, the first and second modulation gates being arranged on a front side of the pixel, above the photoactive region or extending into the photoactive region, a first and a second trench arranged on opposite lateral sides of the photoactive region, the trenches extending from the front side into the pixel, and a first memory part arranged laterally next to the first trench and at least partially separated from the photoactive region by the first trench and a second memory part arranged laterally next to the second trench and at least partially separated from the photoactive region by the second trench, the first and second memory parts being configured to bin electrons generated in the photoactive region when the first, respectively the second modulation gate is active, wherein the first and second trenches comprise air gaps configured to act as reflective structures for photons in the photoactive region.

Various aspects pertain to a method for fabricating an optical sensor, the method comprising: fabricating at least one pixel of the optical sensor by: fabricating a photoactive region configured to convert photons into electrons and holes, fabricating a first and a second modulation gate configured to be modulated for indirect time of flight measurement, the first and second modulation gates being fabricated on a front side of the pixel, above the photoactive region or extending into the photoactive region, fabricating a first and a second trench on opposite lateral sides of the photoactive region, the trenches extending from the front side into the pixel, and fabricating a first memory part laterally next to the first trench such that the first memory part is at least partially separated from the photoactive region by the first trench and fabricating a second memory part laterally next to the second trench such that the second memory part is at least partially separated from the photoactive region by the second trench, the first and second memory parts being configured to bin electrons generated in the photoactive region when the first, respectively the second modulation gate is active, wherein the first and second trenches comprise air gaps configured to act as reflective structures for photons in the photoactive region.

### BRIEF DESCRIPTION OF THE DRAWINGS

The accompanying drawings illustrate examples and together with the description serve to explain principles of the disclosure. Other examples and many of the intended advantages of the disclosure will be readily appreciated in view of the following detailed description. The elements of the drawings are not necessarily to scale relative to each other. Identical reference numerals designate corresponding similar parts.
Figures 1A and 1B show a top view (Fig. 1A) and a sectional view (Fig. 1B) of an exemplary pixel for an optical sensor, wherein the pixel comprises a first and a second trench at least partially separating a first memory part, respectively a second memory part, from a photoactive region of the pixel.
Figure 2 shows a sectional view of the pixel of Fig. 1 according to a particular example, wherein the inner sidewalls of the first and second trenches are coated with a first layer.
Figure 3 schematically shows a photon being reflected from the second trench back into the photoactive region of the pixel.
Figures 4A and 4B show a top view (Fig. 4A) and a sectional view (Fig. 4B) of a further exemplary pixel for an optical sensor, wherein the pixel comprises backside trenches in addition to the first and second trenches.
Figure 5 shows an optical sensor configured to measure a distance between the sensor and an object and/or to measure a velocity of that object.
Figure 6 is a flow chart of a method for fabricating an optical sensor, wherein the method in particular comprises fabricating first and second trenches in the pixel.

### DETAILED DESCRIPTION

In the following detailed description, directional terminology, such as "top", "bottom", "left", "right", "upper", "lower" etc., is used with reference to the orientation of the Figure(s) being described. Because components of the disclosure can be positioned in a number of different orientations, the directional terminology is used for purposes of illustration only. It is to be understood that other examples may be utilized and structural or logical changes may be made.

In addition, while a particular feature or aspect of an example may be disclosed with respect to only one of several implementations, such feature or aspect may be combined with one or more other features or aspects of the other implementations as may be desired and advantageous for any given or particular application, unless specifically noted otherwise or unless technically restricted.

The terms "coupled" and "connected", along with derivatives thereof may be used. It should be understood that these terms may be used to indicate that two elements cooperate or interact with each other regardless whether they are in direct physical or electrical contact, or they are not in direct contact with each other; intervening elements or layers may be provided between the "bonded", "coupled", or "connected" elements. However, it is also possible that the "bonded", "coupled", or "connected" elements are in direct contact with each other. Also, the term "exemplary" is merely meant as an example, rather than the best or optimal.

In several examples layers or layer stacks are applied to one another or materials are applied or deposited onto layers. It should be appreciated that any such terms as "applied" or "deposited" are meant to cover literally all kinds and techniques of applying layers onto each other. In particular, they are meant to cover techniques in which layers are applied at once as a whole as well as techniques in which layers are deposited in a sequential manner.

An efficient optical sensor and an efficient method for fabricating an optical sensor may for example reduce material consumption, ohmic losses, chemical waste, etc. and thus enable energy and/or resource savings. Improved optical sensors and improved methods for fabricating an optical sensor, as specified in this description, may thus at least indirectly contribute to green technology solutions, i.e. climate-friendly solutions providing a mitigation of energy and/or resource use.

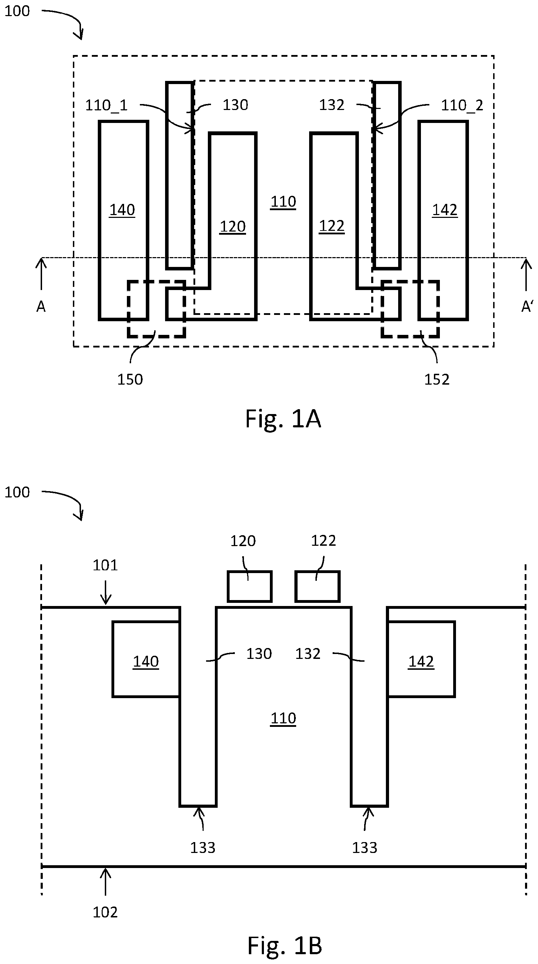

Figure 1A shows a top view of a pixel 100 for an optical sensor and Figure 1B shows a sectional view of the pixel 100 along the line A-A' in Fig. 1A. The optical sensor may comprise a single pixel 100 or a plurality of pixels 100 which may e.g. be arranged in an array. The optical sensor may for example be an active-pixel sensor (APS). The optical sensor may for example be (part of) a time of flight (ToF) sensor device.

The pixel 100 comprises a photoactive region 110, a first modulation gate 120, a second modulation gate 122, a first trench 130, a second trench 132, a first memory part 140 and a second memory part 142. The pixel 100 may comprise any suitable semiconductor material, e.g. Si. The pixel 100 may for example be configured to be sensitive in the infrared (IR) and near-IR spectrum, e.g. for incident light at a wavelength of about 850nm and/or about 940nm.

According to an example, the pixel 100 is configured for backside illumination. According to another example, the pixel 100 is configured for front side illumination.

The photoactive region 110 is configured to convert photons into electrons and holes, for example by the inner photoelectric effect. The photoactive region 110 may be fabricated in one or more epitaxial layers. The photoactive region 110 may for example comprise one or more n-type epitaxial layers, e.g. n-type epitaxial Si layers. The photoactive region 110 may essentially be arranged in the center of the pixel 110. In Fig. 1A, an outline of the photoactive region 110 according to a specific example is shown using dotted lines.

The first and second modulation gates 120, 122 are arranged above the photoactive region 110 or the first and second modulation gates 120, 122 extend into the photoactive region 110 or are wholly arranged within the photoactive region 110. The modulation gates 120, 122 may in particular be arranged at a front side 101 of the pixel 100. The first and second modulation gates 120, 122 are configured to be modulated such that indirect time of flight measurements may be performed with the optical sensor. The modulation gates 120, 122 may for example comprise or consist of poly-Si.

The modulation gates 120, 122 may have any suitable shape and any suitable dimensions. According to a specific example, the modulation gates 120, 122 essentially have an L-shape as shown in Fig. 1A. According to another example, the modulation gates 120, 122 have a rectangular shape, a quadratic shape, etc. The modulation gates 120, 122 may have identical shapes and/or dimensions. The modulation gates 120, 122 may be arranged symmetrically with respect to the trenches 130, 132.

The first trench 130 and the second trench 132 are arranged on opposite lateral sides 110_1 and 110_2 of the photoactive region 110. The photoactive region 110 may in particular be limited by the trenches 130, 132 at the lateral sides 110_1 and 110_2. The first and second trenches 130, 132 extend from the front side 101 of the pixel into the pixel 100.

The trenches 130, 132 may have any suitable shape and any suitable dimensions. The trenches 130, 132 may for example have a rectangular footprint as shown in Fig. 1A. The footprint may for example have a length measured along a longer side of the footprint in the range of about 1µm to about 10µm. The lower limit of this range may also be about 2µm, about 3µm, about 4µm, or about 5µm. The upper limit of this range may also be about 9pm, about 8pm, about 7pm, or about 6µm. The footprint may for example have a width measured along a shorter side of the footprint in the range of about 100nm to about 1µm. The lower limit of this range may also be about 150nm, about 200nm, about 300nm, about 400nm, or about 500nm. The upper limit of this range may also be about 900nm, about 800nm, about 700nm, or about 600nm.

The trenches 130, 132 may for example have an essentially rectangular cross section, as shown in Fig. 1B. The trenches 130, 132 may have any suitable depth measured from the front side 101 to the bottom 133 of the trenches 130, 132. The trenches 130, 132 may for example have a depth in the range of about 3µm to about 10µm. The lower limit of this range may also be about 4µm, or about 5µm and the upper limit may also be about 9pm, about 8pm, about 7pm, or about 6µm.

According to the example shown in Fig. 1B, the first and second trenches 130, 132 do not fully extend from the front side 101 of the pixel 100 to an opposite backside 102. Instead, there is a part under the bottom 133 of the trenches 130, 132, where an interior part of the pixel 100 between the trenches 130, 132 is connected to an exterior part outside of the trenches 130, 132 (the exterior part being to the left of the first trench 130 and to the right of the second trench 132 in Fig. 1B).

The first and second trenches 130, 132 comprise air gaps (in other words, the first and second trenches 130, 132 are filled with air or any other suitable gas). In this manner, the first and second trenches 130, 132 are configured to act as reflective structures for photons in the photoactive region 110. Photons generated in the photoactive region 110 are unable to traverse the trenches 130, 132 but instead will be reflected back into the photoactive region 110.

The first memory part 140 is arranged laterally next to the first trench 130. Furthermore, the first memory part 140 is at least partially separated from the photoactive region 110 by the first trench 130. "At least partially separated" may mean that the first memory part 140 is connected to the photoactive region 110 only at a first bridge region 150, wherein the first trench 130 does not extend into the first bridge region 150. The first bridge region 150 is indicated by dashed lines in Fig. 1A.

The second memory part 142 is arranged laterally next to the second trench 132. Furthermore, the second memory part 142 is least partially separated from the photoactive region 110 by the second trench 132. The second memory part 142 may for example be connected to the photoactive region 110 only at a second bridge region 152, wherein the second trench 132 does not extend into the second bridge region 152. The second bridge region 152 is also indicated by dashed lines in Fig. 1A. The memory parts 140, 142 may for example be arranged below the surface of the front side 101. The memory parts 140, 142 may be arranged closer to the front side 101 than to the backside 102.

According to an example, the first and second bridge regions 150, 152 comprise an electrical-field-optimizing implant configured to facilitate a transfer of electrons from the photoactive region 110 to the respective one of the memory parts 140, 142. The electrical-field-optimizing implant may for example comprise a p-implant close to the front side 101 and an n-implant deeper below the front side 101.

According to an example, a length of the first and second bridge regions 150, 152 (the length being measured parallel to the longer side of the trenches 130, 132 in Fig. 1A) is no more than half of a length of the first and second trenches 130, 132. The length of the bridge regions 150, 52 may also be no more than one third, no more than one quarter, or no more than one fifth of the length of the trenches 130, 132. Furthermore, no more than 50%, or no more than 40%, or no more than 30%, or no more than 20% of a length of the memory parts 140, 142 may be coupled to the bridge regions 150, 152, whereas the remainder of the length of the trenches 140, 142 may be decoupled from the photoactive region 110 by the trenches 130, 132.

The first and second memory parts 140, 142 are configured to bin electrons generated in the photoactive region 110 when the first modulation gate 120, respectively the second modulation gate 122 is active.

According to an example, the first and second memory parts 140, 142 are memory nodes of the pixel 100. According to another example, the first and second memory parts 140, 142 are pinned diodes of the pixel 100. The memory parts 140, 142 may for example comprise an n-doped region of the pixel 100. The memory parts 140, 142 may be surrounded by p-wells of the pixel 100.

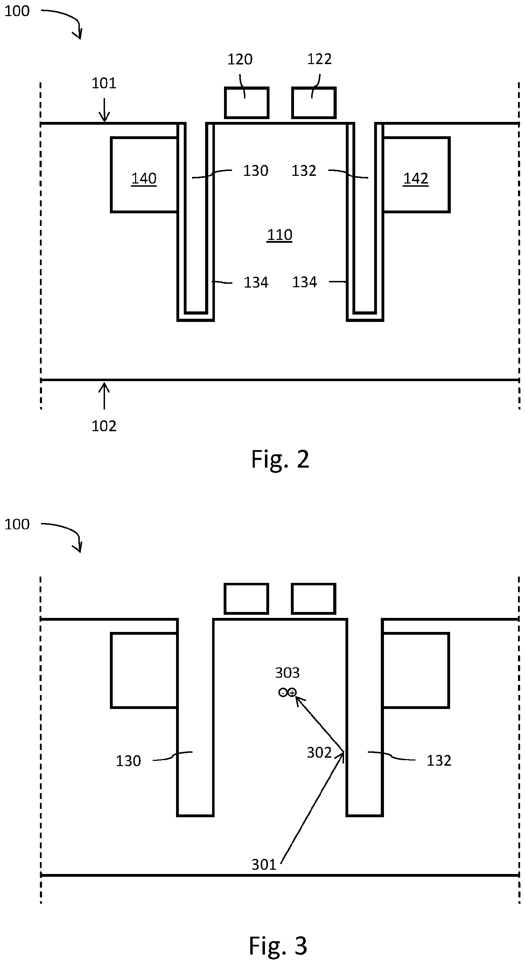

Figure 2 shows a sectional view of the pixel 100 according to a specific example. In the example of Fig. 2, inner sidewalls of the first and second trenches 130, 132 are covered by a first layer 134. The first layer 134 may completely cover the inner sidewalls of the trenches 130, 132. It is possible that the first layer 134 covers not only the inner sidewalls of the trenches 130, 132 but also the front side 101 and/or the backside 102 of the pixel 100.

According to an example, the first layer 134 is or comprises a thermal oxide layer. The thermal oxide layer may for example comprise or consist of Al₂O₃. The thermal oxide layer may have any suitable thickness, e.g. a thickness in the range of about 1nm to about 10nm. The lower limit of this range may also be about 2nm, about 3nm, about 4nm, or about 5nm. The upper limit of this range may also be about 9nm, about 8nm, about 7nm, or about 6nm.

According to an example, the first layer 134 is or comprises a poly-Si layer. The poly-Si layer may have any suitable thickness, e.g. a thickness in the range of about 10nm to about 50nm. The lower limit of this range may also be about 15nm, about 20nm, or about 25nm. The upper limit of this range may also be about 40nm, about 35nm, or about 30nm.

According to an example, the first layer 134 is or comprises a TiN layer. The TiN layer may have any suitable thickness, e.g. a thickness in the range of about 10nm to about 50nm. The lower limit of this range may also be about 15nm, about 20nm, or about 25nm. The upper limit of this range may also be about 40nm, about 35nm, or about 30nm.

The first layer 134 may for example be a layer stack comprising or consisting of both the thermal oxide layer and the poly-Si layer. The first layer 134 may for example be a layer stack comprising or consisting of both the thermal oxide layer and the TiN layer. The first layer 134 may for example be a layer stack comprising or consisting of both the poly-Si layer and the TiN layer. It is also possible that the first layer 134 is a layer stack comprising or consisting of the thermal oxide layer, the poly-Si layer and the TiN layer. The individual layers of the layer stack may be arranged relative to each other in any possible order, for example the thermal oxide layer on the inner side walls of the trenches 130, 132, the poly-Si layer on the thermal oxide layer and the TiN layer on the poly-Si layer.

In any case, the width of the trenches 130, 132 comprising the first layer 134 (in other words, the width of the air gap within the trenches 130, 132 comprising the first layer 134) may be in the range described further above with respect to Fig. 1A.

The poly-Si layer and/or the TiN layer may be configured as an electrically conductive coating arranged within the trenches 130, 132. This electrically conductive coating may be electrically coupled to contacts on the front side 101 of the pixel 100. For example, the electrically conductive coating of the first trench 130 may be coupled to a first contact and the electrically conductive coating of the second trench 132 may be coupled to a second contact.

According to an example, the pixel 100 is configured to have a negative potential applied to the conductive coating of the first and/or second trench 130, 132 during an integration time interval. This negative potential may cause an accumulation of holes at the surface which in turn may reduce a dark current of the pixel 100 (due to trapping of dark current electrons). Applying such a negative potential to the trenches 130, 132 may also help with a high full-well-capacitance in the memory parts 140, 142.

Furthermore, at the end of the integration time interval, a second, stronger negative potential may be applied to the conductive coating of the first and/or second trench 130, 132, such that electrons collected in the first and/or second memory parts 140, 142 are pushed out towards a first and/or second floating diffusion in order to read out the pixel 100. In this manner, the memory parts 140, 142 may be drained more quickly which in turn may improve the performance of the pixel 100.

Figure 3 schematically shows an additional or alternative benefit of having the pixel 100 equipped with the first and second trenches 130, 132.

As shown in Fig. 3, at 301, a photon enters the photoactive region 110 of the pixel 100. At 302, the photon would exit the photoactive region 110 because it has not been absorbed. However, the second trench 132 acts as a reflective structure which reflects the photon back into the photoactive region 110. The reflective properties of the trenches 130, 132 may be due to the air gap within the trenches 130, 132. In particular, the air gap may have to have a sufficient width in order for the trenches 130, 132 to reflect photons of a particular wavelength. The trenches 130, 132 may for example have to have a width in the range described further above with respect to Fig. 1A.

At 303, the reflected photon creates an electron-hole-pair in the photoactive region 110 due to the inner photoelectric effect. If the photon had been able to exit the photoactive area 110 and instead had generated the electron-hole-pair in one of the memory parts 140, 142, the noise level in the pixel 100 would have been increased. This is because electrons generated in the memory parts 140, 142, instead of in the photoactive area 110, are not modulated by the modulation gates 120, 122. Also, electrons may be generated in the memory parts 120, 122 after the integration time period of the pixel 100 has already expired. These noise effects may be termed "parasitic light sensitivity" (PLS). However, by optically insulating the memory parts 120, 122 using the trenches 130, 132, this source of noise may be eliminated or at least mitigated.

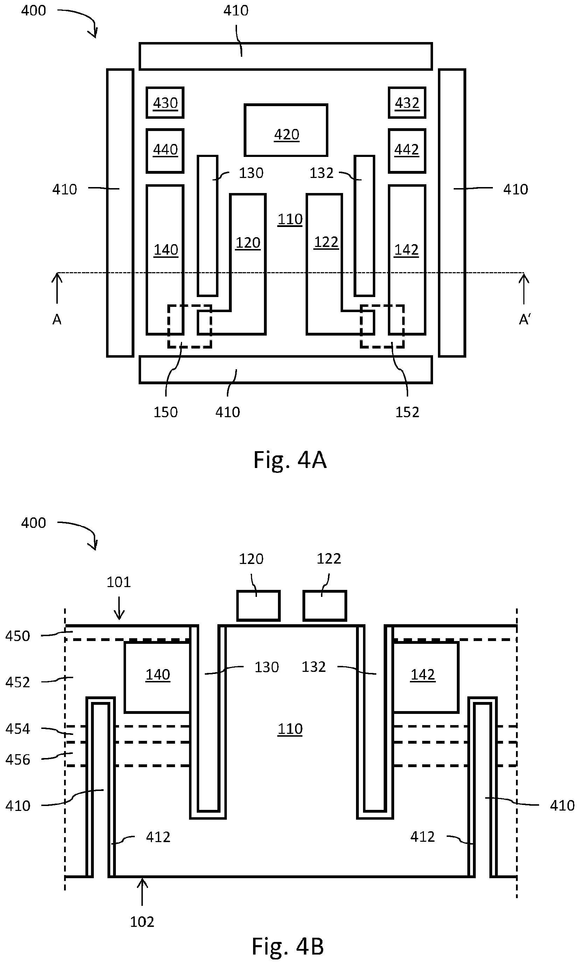

Figures 4A and 4B show a further pixel 400, which may be similar or identical to the pixel 100, except for the differences described in the following. Fig. 4A shows a top view and Fig. 4B shows a sectional view along the line A-A' in Fig. 4A.

In particular, the pixel 400 may comprise all components described with respect to the pixel 100 and the pixel 400 may additionally comprise further trenches 410. The pixel 400 may comprise any suitable number of further trenches 410, for example four further trenches 410.

As shown in Fig. 4B, the further trenches 410 extend into the pixel 400 from the backside 102, whereas the first and second trenches 130, 132 extend into the pixel 400 from the front side 101. For this reason, the first and second trenches 130, 132 may also be termed "front side trenches", whereas the further trenches 410 may also be termed "backside trenches".

The pixel 400 may be part of an array of pixels of an optical sensor. The further trenches 410 may for example be configured to electrically and/or optically and/or mechanically separate the pixel 400 from neighboring pixels of the array. The further trenches 410 may laterally delimit the pixel 400 from other parts (e.g. other pixels) of the optical sensor.

The further trenches 410 may essentially have the same or similar dimensions as described further above with respect to the first and second trenches 130, 132. However, it is also possible that the further trenches 410 have different dimensions, e.g. larger or smaller dimensions.

According to an example, the inner sidewalls of the further trenches 410 are covered by a second layer 412. The second layer 412 may have the same or a similar material composition and/or the same or a similar thickness as described further above with respect to the first layer 134. In particular, the second layer may comprise or consist of a thermal oxide layer. According to an example, the second layer 412 does not comprise the electrically conductive coating which the first layer 134 may or may not comprise.

According to an example, the pixel 400 further comprises a drain terminal 420. The drain terminal 420 may be arranged on the front side 101 of the pixel 400. The drain terminal 420 may e.g. be arranged over the photoactive region 110 or laterally shifted to the side of the photoactive region 110.

According to an example, the pixel 400 may further comprise a first floating diffusion 430 and a second floating diffusion 432. The first floating diffusion 430 may be arranged on the same lateral side of the pixel 400 as the first memory part 140 and the second floating diffusion 432 may be arranged on the same lateral side of the pixel 400 as the second memory part 142. The first and second floating diffusions 430, 432 may be configured as readout parts of the pixel 400 and may be electrically coupled to readout circuitry of the optical sensor.

According to an example, the pixel 400 may further comprise a first transfer gate 440 and a second transfer gate 442. The first transfer gate 440 may be arranged between the first memory part 140 and the first floating diffusion 430 and the second transfer gate 442 may be arranged between the second memory part 142 and the second floating diffusion 432. The first and second transfer gates 440, 442 may be configured to transfer electrons accumulated in the first and second memory parts 140, 142 to the first and second floating diffusions 430, 432 at the end of the integration time interval for readout of the pixel 400.

As indicated by the dotted lines in Fig. 4B, the pixel 400 may comprise several semiconductor layers with different types of dopant. For example, a first semiconductor layer 450 may be a p-type layer. A second semiconductor layer 452 may also be a p-type layer, wherein the second semiconductor layer 452 has a higher or a lower p-dopant concentration than the first semiconductor layer 450. A third semiconductor layer 454 may be a p-type layer with a higher p-dopant concentration than the second semiconductor layer 452. A fourth semiconductor layer 456 may be a p-type layer and may for example have the same p-dopant concentration as the second semiconductor layer 452. The second and the fourth semiconductor layers 452, 456 may for example form a p-well. The photoactive region 110 may comprise an n-type dopant.

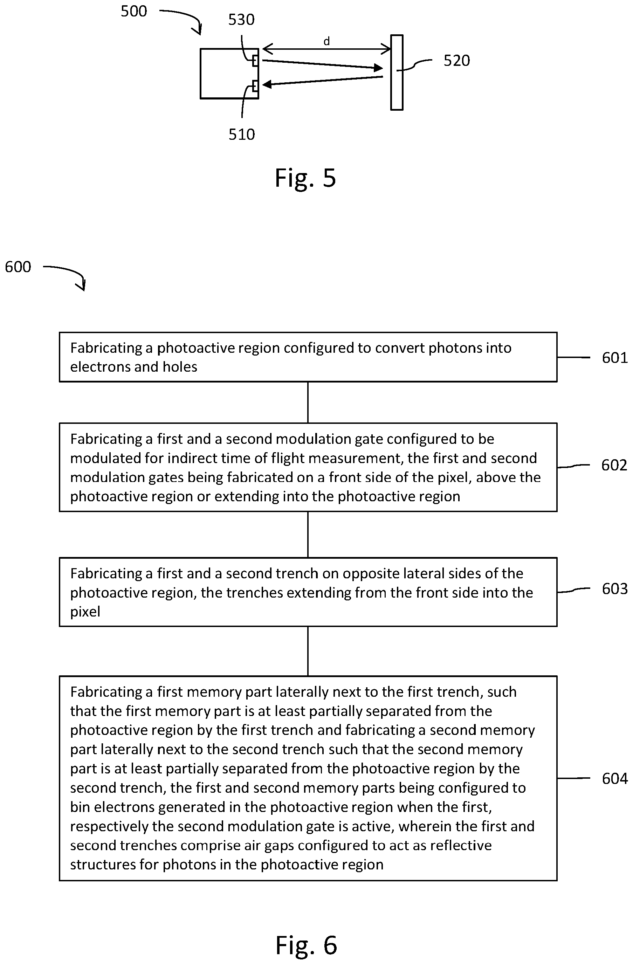

Figure 5 shows an exemplary optical sensor unit 500 which may comprise a sensor part 510 with one or more pixels 100 or 400, in particular an array of pixels 100 or 400. The optical sensor unit 500 may for example be a time of flight (ToF) sensor unit configured to measure a distance d to an object 520 and/or a speed of the object 520. According to an example, the optical sensor unit 500 also comprises an emitter part 530 configured for emitting photons. According to another example, the sensor part 510 and the emitter part 530 are part of separate units.

According to an example, the optical sensor unit 500 (and consequently, the pixel 100 or 400) is configured for front side illumination. According to another example, the optical sensor unit 500 (and consequently, the pixel 100 or 400) is configured for backside illumination.

Figure 6 is a flow chart of a method 600 for fabricating an optical sensor. The method 600 comprises fabricating at least one pixel of the optical sensor.

At 601, method 600 comprises an act of fabricating a photoactive region configured to convert photons into electrons and holes. At 602, method 600 comprises an act of fabricating a first and a second modulation gate configured to be modulated for indirect time of flight measurement, the first and second modulation gates being fabricated on a front side of the pixel, above the photoactive region or extending into the photoactive region. At 603, method 600 comprises an act of fabricating a first and a second trench on opposite lateral sides of the photoactive region, the trenches extending from the front side into the pixel. At 604, method 600 comprises an act of fabricating a first memory part laterally next to the first trench, such that the first memory part is at least partially separated from the photoactive region by the first trench and fabricating a second memory part laterally next to the second trench such that the second memory part is at least partially separated from the photoactive region by the second trench, the first and second memory parts being configured to bin electrons generated in the photoactive region when the first, respectively the second modulation gate is active, wherein the first and second trenches comprise air gaps configured to act as reflective structures for photons in the photoactive region.

According to an example, method 600 may comprise an optional act of implanting an electrical field optimizing implant into a first bridge region coupling the photoactive region to the first memory part and into a second bridge region coupling the photoactive region to the second memory part. Furthermore, the act 603 of fabricating the first and second trenches may for example comprise using a suitable etching process, in particular an anisotropic etching process. The method 600 may also comprise an act of fabricating the backside trenches described with respect to Figs. 4A and 4B. The backside trenches may also be fabricated using an etching process.

The method 600 may further comprise an act of coating the first and second trenches with the first layer and/or an act of coating the backside trenches with the second layer. This may comprise using a heat application process, e.g. in an oven, in order to fabricate the thermal oxide layer and/or using any suitable coating technique in order to apply the electrically conductive coating.

### EXAMPLES

In the following, an optical sensor and a method for fabricating an optical sensor are further explained using specific examples.

Example 1 is an optical sensor, comprising: at least one pixel, comprising: a photoactive region configured to convert photons into electrons and holes, a first and a second modulation gate configured to be modulated for indirect time of flight measurement, the first and second modulation gates being arranged on a front side of the pixel, above the photoactive region or extending into the photoactive region, a first and a second trench arranged on opposite lateral sides of the photoactive region, the trenches extending from the front side into the pixel, and a first memory part arranged laterally next to the first trench and at least partially separated from the photoactive region by the first trench and a second memory part arranged laterally next to the second trench and at least partially separated from the photoactive region by the second trench, the first and second memory parts being configured to bin electrons generated in the photoactive region when the first, respectively the second modulation gate is active, wherein the first and second trenches comprise air gaps configured to act as reflective structures for photons in the photoactive region.

Example 2 is the optical sensor of example 1, wherein the air gaps have a width measured parallel to the front side of 150nm or more.

Example 3 is the optical sensor of example 1 or 2, wherein sidewalls of the first and second trenches are coated with an Al₂O₃ layer.

Example 4 is the optical sensor of example 3, further comprising: an electrically conductive coating arranged on the Al₂O₃ layer and electrically connected to contacts on the front side.

Example 5 is the optical sensor of example 4, wherein the pixel is configured to have a negative potential applied to the conductive coating of the first and/or second trench such that electrons collected in the first and/or second memory parts are pushed out towards a first and/or second floating diffusion of the pixel and/or such that a hole accumulation due to the applied negative potential reduces a dark current in the pixel.

Example 6 is the optical sensor of example 4 or 5, wherein the conductive coating comprises a poly-Si layer and/or a TiN layer.

Example 7 is the optical sensor of one of the preceding examples, wherein the photoactive region is coupled to the first memory part at a first bridge region and to the second memory part at a second bridge region, and wherein the first and second bridge regions comprise an electrical-field-optimizing implant configured to facilitate a transfer of electrons from the photoactive region to the respective memory part.

Example 8 is the optical sensor of example 7, wherein a length of the first and second bridge regions is no more than half of a length of the first and second trenches, the length being measured along a longer side of the first and second trenches, parallel to the front side.

Example 9 is the optical sensor of example 7 or 8, wherein the electrical-field-optimizing implant comprises a p-implant close to the front side and an n-implant deeper below the front side.

Example 10 is the optical sensor of one of the preceding examples, wherein the first and second modulation gates have an L-shape according to a top view directed towards the front side of the pixel.

Example 11 is the optical sensor of one of the preceding examples, further comprising: at least one backside trench extending from a backside of the pixel into the pixel towards the front side, the backside trench separating the pixel from a further pixel of the optical sensor.

Example 12 is the optical sensor of one of the preceding examples, wherein the first and second trenches are partial trenches with a respective gap between the bottoms of the first and second trenches and the backside.

Example 13 is a method for fabricating an optical sensor, the method comprising: fabricating at least one pixel of the optical sensor by: fabricating a photoactive region configured to convert photons into electrons and holes, fabricating a first and a second modulation gate configured to be modulated for indirect time of flight measurement, the first and second modulation gates being fabricated on a front side of the pixel, above the photoactive region or extending into the photoactive region, fabricating a first and a second trench on opposite lateral sides of the photoactive region, the trenches extending from the front side into the pixel, and fabricating a first memory part laterally next to the first trench such that the first memory part is at least partially separated from the photoactive region by the first trench and fabricating a second memory part laterally next to the second trench such that the second memory part is at least partially separated from the photoactive region by the second trench, the first and second memory parts being configured to bin electrons generated in the photoactive region when the first, respectively the second modulation gate is active, wherein the first and second trenches comprise air gaps configured to act as reflective structures for photons in the photoactive region.

Example 14 is the method of example 13, wherein fabricating the first and second trenches comprises applying an electrically conductive coating to sidewalls of the trenches and electrically coupling the conductive coating to contacts on the front side of the pixel.

Example 15 is the method of example 13 or 14, further comprising: implanting an electrical field optimizing implant into a first bridge region coupling the photoactive region to the first memory part and into a second bridge region coupling the photoactive region to the second memory part.

Example is an apparatus comprising means for performing the method according to anyone of examples 13 to 15.

While the disclosure has been illustrated and described with respect to one or more implementations, alterations and/or modifications may be made to the illustrated examples without departing from the spirit and scope of the appended claims. In particular regard to the various functions performed by the above described components or structures (assemblies, devices, circuits, systems, etc.), the terms (including a reference to a "means") used to describe such components are intended to correspond, unless otherwise indicated, to any component or structure which performs the specified function of the described component (e.g., that is functionally equivalent), even though not structurally equivalent to the disclosed structure which performs the function in the herein illustrated exemplary implementations of the disclosure.

## Claims

1. An optical sensor (500), comprising:
at least one pixel (100, 400), comprising:
a photoactive region (110) configured to convert photons into electrons and holes,
a first and a second modulation gate (120, 122) configured to be modulated for indirect time of flight measurement, the first and second modulation gates (120, 122) being arranged on a front side (101) of the pixel (100, 400), above the photoactive region (110) or extending into the photoactive region (110),
a first and a second trench (130, 132) arranged on opposite lateral sides (110_1, 110_2) of the photoactive region (110), the trenches (130, 132) extending from the front side (101) into the pixel (100, 400), and
a first memory part (140) arranged laterally next to the first trench (130) and at least partially separated from the photoactive region (110) by the first trench (130) and a second memory part (142) arranged laterally next to the second trench (132) and at least partially separated from the photoactive region (110) by the second trench (132), the first and second memory parts (140, 142) being configured to bin electrons generated in the photoactive region (110) when the first, respectively the second modulation gate (120, 122) is active,
wherein the first and second trenches (130, 132) comprise air gaps configured to act as reflective structures for photons in the photoactive region (110).

2. The optical sensor (500) of claim 1, wherein the air gaps have a width measured parallel to the front side of 150nm or more.

3. The optical sensor (500) of claim 1 or 2, wherein sidewalls of the first and second trenches (130, 132) are coated with an Al₂O₃ layer (134) .

4. The optical sensor (500) of claim 3, further comprising:
an electrically conductive coating (134) arranged on the Al₂O₃ layer (134) and electrically connected to contacts on the front side (101).

5. The optical sensor (500) of claim 4, wherein the pixel (100, 400) is configured to have a negative potential applied to the conductive coating (134) of the first and/or second trench (130, 132) such that electrons collected in the first and/or second memory parts (140, 142) are pushed out towards a first and/or second floating diffusion (430, 432) of the pixel (100, 400) and/or such that a hole accumulation due to the applied negative potential reduces a dark current in the pixel (100, 400).

6. The optical sensor (500) of claim 4 or 5, wherein the conductive coating (134) comprises a poly-Si layer and/or a TiN layer.

7. The optical sensor (500) of one of the preceding claims, wherein the photoactive region (110) is coupled to the first memory part (140) at a first bridge region (150) and to the second memory part (142) at a second bridge region (152), and
wherein the first and second bridge regions (150, 152) comprise an electrical-field-optimizing implant configured to facilitate a transfer of electrons from the photoactive region (110) to the respective memory part (140, 142).

8. The optical sensor (500) of claim 7, wherein a length of the first and second bridge regions (150, 152) is no more than half of a length of the first and second trenches (130, 132), the length being measured along a longer side of the first and second trenches (130, 132), parallel to the front side (101).

9. The optical sensor (500) of claim 7 or 8, wherein the electrical-field-optimizing implant comprises a p-implant close to the front side (101) and an n-implant deeper below the front side (101).

10. The optical sensor (500) of one of the preceding claims, wherein the first and second modulation gates (120, 122) have an L-shape according to a top view directed towards the front side (101) of the pixel (100, 400).

11. The optical sensor (500) of one of the preceding claims, further comprising:
at least one backside trench (410) extending from a backside (102) of the pixel (100, 400) into the pixel (100, 400) towards the front side (101), the backside trench (410) separating the pixel (100, 400) from a further pixel of the optical sensor (500).

12. The optical sensor (500) of one of the preceding claims, wherein the first and second trenches (130, 132) are partial trenches with a respective gap between the bottoms (133) of the first and second trenches and the backside (102).

13. A method (600) for fabricating an optical sensor, the method comprising:
fabricating at least one pixel of the optical sensor by:
fabricating (601) a photoactive region configured to convert photons into electrons and holes,
fabricating (602) a first and a second modulation gate configured to be modulated for indirect time of flight measurement, the first and second modulation gates being fabricated on a front side of the pixel, above the photoactive region or extending into the photoactive region,
fabricating (603) a first and a second trench on opposite lateral sides of the photoactive region, the trenches extending from the front side into the pixel, and
fabricating (604) a first memory part laterally next to the first trench such that the first memory part is at least partially separated from the photoactive region by the first trench and fabricating a second memory part laterally next to the second trench such that the second memory part is at least partially separated from the photoactive region by the second trench, the first and second memory parts being configured to bin electrons generated in the photoactive region when the first, respectively the second modulation gate is active,
wherein the first and second trenches comprise air gaps configured to act as reflective structures for photons in the photoactive region.

14. The method (600) of claim 13, wherein fabricating (603) the first and second trenches comprises applying an electrically conductive coating to sidewalls of the trenches and electrically coupling the conductive coating to contacts on the front side of the pixel.

15. The method (600) of claim 13 or 14, further comprising:
implanting an electrical field optimizing implant into a first bridge region coupling the photoactive region to the first memory part and into a second bridge region coupling the photoactive region to the second memory part.
